# EUROPEAN PATENT APPLICATION

(11) **EP 4 293 716 A1**
(43) Date of publication of application: **20.12.2023**
(21) Application number: 23178319.2
(22) Date of filing: 09.06.2023
(51) Int. Cl.: H01L 23/495, H01L 21/56, H01L 23/00

(54) **THIN SUBSTRATE PACKAGE AND LEAD FRAME**

(30) Priority: 16.06.2022 US 202263352981 P; 06.06.2023 US 202318330284
(71) Applicant: STMicroelectronics, Inc., 4027 Calamba City, Laguna (PH)
(72) Inventor: TALLEDO, Jefferson, 4027 Calamba (PH)
(74) Representative: Cabinet Beaumont

(57) **Abstract**

The present disclosure is directed to a thin substrate package and a lead frame method of fabricating the semiconductor package (100). The semiconductor package includes a first lead frame portion (109) and a second lead frame portion (104). A substrate (102) is positioned in a center opening (118) between the first lead frame portion and the second lead frame portion, the substrate having a thickness less than or equal to 0.10-millimeters (mm). A first die (110) having a plurality of wires is positioned on the substrate by an adhesive (108). A molding compound (116) covers the first and second lead frame portions, the substrate, and the first die.

## Description

### BACKGROUND

### Technical Field

The present disclosure relates to a thin substrate packaging structure with a lead frame.

### Description of the Related Art

Innovative contributions in the semiconductor packaging industry have contributed greatly to the advancement of technology - whether in electronics or other technological sectors throughout the world. However, improvements are always being developed within the art and continue to warrant new and innovative ways to further progress in the industry. With increased demand in the miniaturization of semiconductor packaging, manufacturers are developing packages and methods that can meet and exceed that demand. Particularly, processes and methods that involve handling substrates with a relatively thin thickness remain increasingly difficult as manufacturers seek innovative integrated circuits having smaller, faster, and higher-performing semiconductor packages.

Attempts to assemble semiconductor packages with relatively thin substrates remain challenging for a variety of reasons, one of which is due to strip handling issues. For example, when attempting to handle substrate strips with a lower thickness, the strips become flimsy and inhibit consistent handling of the substrate. This particular issue remains especially prevalent in dealing with large strips having an approximate size of 240 x 74 millimeters. Such an issue impacts fabricating substrates unusable and unable to meet the present demand for smaller semiconductor packaging.

### BRIEF SUMMARY

In a substrate package and method embodying the principles of the disclosure, a thin organic laminate substrate is placed in the center of a lead frame unit, thus reducing strip handling issues during package assembly processes and creating a smaller, lighter, and efficient semiconductor package. Fabricating a thin substrate has proven difficult due to strip handling issues during the packaging process and fragility of an end product. The present disclosure is directed to utilizing lead frame portions as stiffeners or supports with thin organic laminate substrates between the lead frame portions. Enabling the lead frames to act as stiffeners increases the stability of the thin substrate during packaging and in use. This also creates a substantially smaller semiconductor package as a height or dimension of the lead frame portion is greater than a height of the thin substrate.

In accordance with the disclosure, a very thin substrate is between lead frame portions where the thin substrate is less than a height of the lead frame portions. One or more die are on the thin substrate between the lead frame portions. A first lead frame portion includes a first and a second contact surface. A second lead frame portion includes a first and a second contact surface. The first and second lead frame portions include a first sidewall and a second sidewall, the first and second sidewall having a dimension less than or equal to 0.20 millimeters (mm). A center opening is between the first sidewall of the first lead frame portion and the first sidewall of the second lead frame portion, i.e. these are internal facing sidewalls.

The substrate is in the center opening between the first and second lead frame portions. The thin substrate includes a first contact surface and a second contact surface, the first contact surface having a plurality of contact pads. The thin substrate includes a third sidewall transverse to the first and second contact surface, the third sidewall having a dimension less than or equal to 0.10 millimeters (mm).

A first die is on the substrate and includes a first contact surface with a plurality of contact pads. The first die further includes a fourth sidewall, the fourth sidewall transverse to the first contact surface. A plurality of wires are coupled between the die and the substrate and between the die and the lead frame portions. Additionally, a molding compound encapsulates the lead frame portions, the substrate, the first die, and the first and second pair of wires.

An embodiment provides:
a first lead frame portion having a first contact surface opposite to a second contact surface, and a first sidewall transverse to the first and second contact surface;
a second lead frame portion having a first contact surface opposite to a second contact surface;
a center opening between the first lead frame portion and the second lead frame portion;
a substrate in the center opening between the first lead frame portion and the second lead frame portion, the substrate having a first surface and a second surface opposite the first surface, a second sidewall, the second sidewall being smaller than the first sidewall;
a first die on the substrate, the first die having a third sidewall, the first sidewall being larger than the second sidewall and the third sidewall; and
a molding compound covering the first and second lead frame portions, the first die, and the substrate.

According to an embodiment, the first lead frame portion and the second lead frame portion have a first sidewall dimension of less than or equal to 0.20 millimeters (mm).

According to an embodiment, the substrate has a second sidewall dimension of less than or equal to 0.10 millimeters (mm).

According to an embodiment, the molding compound has a dimension of the combination of the first sidewall, the second sidewall, and the third sidewall.

According to an embodiment, the first die is a micro-electromechanical system.

According to an embodiment, the first lead frame portion includes a fourth external sidewall transverse to the first and second contact surface, the fourth external sidewall substantially the same as the first sidewall; and the fourth external sidewall being greater than the second sidewall of the substrate.

According to an embodiment, a fourth dimension of the peak curvature of a plurality of connectors on the second surface of the first die is equal to or less than 0.05 millimeters (mm).

According to an embodiment, the substrate is composed of an organic laminate material.

According to an embodiment, the first surface of the substrate has a plurality of contacts coplanar with the first contact surface of the first and second lead frame portions.

According to an embodiment, the device further comprises a plurality of solder balls coupled to the plurality of contact pads on the first contact surface of the substrate and the first contact surface of the first and second lead frame portions.

According to an embodiment, the molding compound is composed of resin.

An embodiment provides a device, comprising:
a lead frame having a first dimension in a first direction;
an opening in the lead frame;
a substrate in the opening in the lead frame, the substrate having a second dimension in the first direction, the first dimension being greater than the second dimension; and
a first die on the substrate, the first die and the substrate having a third dimension in the first direction, the first dimension being greater than the third dimension.

According to an embodiment, the device further comprises a plurality of wires, a first set of the plurality of wires coupled between the first die and the substrate, a second set of the plurality of wires coupled between the first die and the lead frame.

According to an embodiment, the substrate has a first surface opposite a second surface, the first die being on the first surface, at least one of the plurality of wires has a curvature where a fourth dimension from a peak of the curvature to the second surface of the substrate is less than or equal to 0.20 millimeters (mm).

According to an embodiment, the device further comprises a molding compound covering the lead frame, the opening, the substrate, and the first die.

According to an embodiment, a fifth dimension including the molding compound is equal to or greater than the summation of the first, second, third, and fourth dimensions.

An embodiment provides a method, comprising:
forming a plurality of layers on a carrier tape using a lead frame, forming a plurality of layers including:
forming a plurality of lead frame portions, the lead frame portions having a first side opposite a second side, a first surface coupled to the carrier tape, opposite a second surface transverse to the first side and second side; the first side facing a center opening between the lead frame portions and the second side facing externally;
placing a substrate in the center opening between the lead frame portions, the substrate having a first surface opposite a second surface;
coupling a first die to the substrate by an adhesive, the first die having a first surface opposite a second surface;
forming a molding compound encapsulating the lead frame portions, the substrate, the first die, and the plurality of wires; and
singulating a portion of the lead frame portions, the substrate, the first die, the plurality of wires, and the molding compound forming a semiconductor package.

According to an embodiment, the plurality of wires are placed on the first die having a curvature height equal to or less than 0.05 millimeters (mm).

According to an embodiment, singulating the portion of the lead frame portions creates a new external sidewall of the first and second lead frame portions.

According to an embodiment, the lead frame portions, the substrate, the first die, and the molding compound have a total combination thickness of less than or equal to 1.0 millimeter (mm).

### BRIEF DESCRIPTION OF THE SEVERAL VIEWS OF THE DRAWINGS

Figure 1 is a cross-sectional view of an embodiment of a semiconductor package of the present disclosure.
Figure 2 is a cross-sectional view of an embodiment of the semiconductor package of the present disclosure.
Figure 3 is a cross-sectional view of an embodiment of the semiconductor package of the present disclosure.
Figures 4A-4E are cross-sectional views of a method of manufacturing the semiconductor package in Figure 1.

### DETAILED DESCRIPTION

In the ensuing description, certain specific details are set forth in order to provide a thorough understanding of various disclosed embodiments. However, one skilled in the relevant art will recognize that embodiments may be practiced without one or more of these specific details, or with other methods, components, materials, etc.

Reference throughout this specification to "one embodiment" or "an embodiment" means that a particular feature, structure or characteristic described in connection with the embodiment is included in at least one embodiment. Thus, the appearance of the phrases "in one embodiment" or "in the embodiment" in various places throughout this specification are not necessarily all referring to the same embodiment. Furthermore, the particular features, structures, or characteristics may be combined in any suitable manner in one or more embodiments.

The present disclosure relates to a thin substrate semiconductor package utilizing lead frame portions to function as a stiffener or support during the manufacturing process and in use. Thin substrates are not easily placed in a semiconductor package due to the flexibility of the material when less than a threshold dimension. As noted above, the present disclosure utilizes lead frame portions as a stabilizing structure within the semiconductor package, where thin substrates can be positioned on a lead frame carrier tape without getting easily bent or crumbled. Decreasing the size of the substrates allows for a decreased size in the overall semiconductor package while including supportive structure for transport and assembly in a final product.

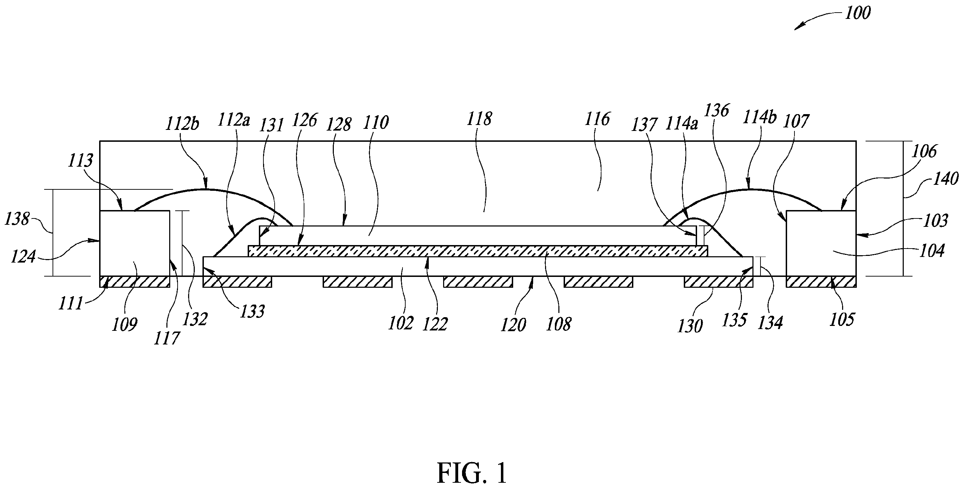

Figure 1 is directed to a cross-sectional view of a preferred embodiment of a semiconductor package 100. The semiconductor package 100 includes a first lead frame portion 109 and a second lead frame portion 104. A substrate 102 is positioned in a center opening 118 between the first lead frame portion 109 and the second lead frame portion 104, covered by a molding compound 116.

The first lead frame portion 109 includes a first contact surface 111 and a second contact surface 113, the second contact surface 113 being opposite to the first contact surface 111. The first lead frame portion has a first internal sidewall 117 transverse to the first and second contact surface 111, 113, respectively. The first internal sidewall 117 having a first sidewall dimension or thickness 132 is adjacent to the substrate 102, opposite a first external sidewall 124. The first sidewall thickness 132 extends from the first contact surface 111 of the first lead frame portion 109 to the second contact surface 113, the first sidewall thickness 132 has a thickness range of less than or equal to 0.20-millimeters (mm).

The second lead frame portion 104 includes a first contact surface 105 and a second contact surface 106, the second contact surface 106 being opposite to the first contact surface 105. The second lead frame portion 104 further includes a second internal sidewall 107. The second internal sidewall 107 is transverse to the first and second contact surfaces 105, 106, respectively. A second external sidewall 103 is opposite the second internal sidewall 107 and is transverse to the first and second contact surfaces 105, 106 of the second lead frame portion 104. The second internal sidewall 107 has a thickness substantially equal to the first sidewall thickness 132. The second internal sidewall 107 and second external sidewall 103 extend from the first contact surface 105 of the second lead frame portion 104 to the second contact surface 106.

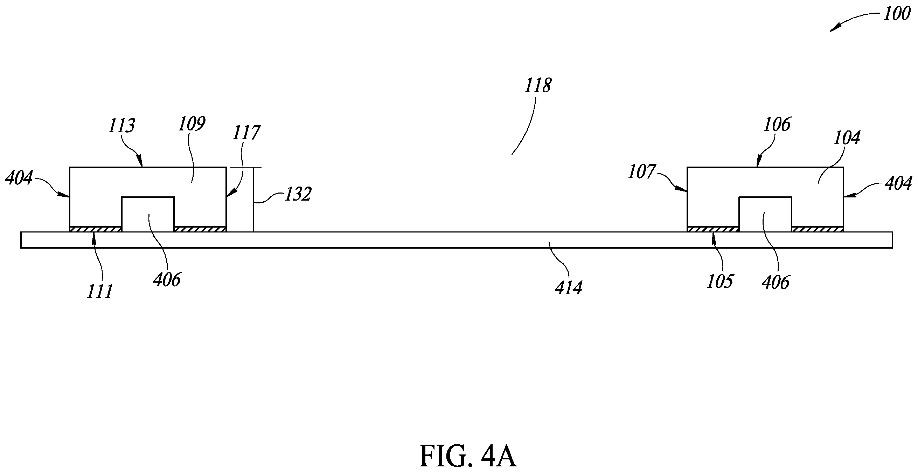

The first and second lead frame portions 104, 109 are coupled to an adjacent lead frame (not shown) during assembly of the package, such as through a tie bar (not shown). The lead frame is one part of an array of lead frames. The tie bar is separated and/or removed during the singulation process which will be described in further detail below with respect to Figures 4A-4E.

The center opening 118 extends from the first internal sidewall 117 of the first lead frame portion 109 to the second internal sidewall 107 of the second lead frame portion 104. Typically, in a standard package known in the art, a center opening includes a die pad composed of lead frame material, such as copper or other similar materials. However, the present disclosure includes a thin substrate 102 that is a different material than the lead frame portions. The lead frame portions are metal, such as copper. The thin substrate may be a laminate substrate, such as a printed circuit board with fibers and resin. The resin maybe a bismaleimide triazine resin or other suitable non-conductive material. The substrate may include a plurality of electrical connections, like a redistribution layer as beneficial for the end product.

In the present disclosure the substrate is thinner than the first and second lead frame portions 109, 104. The lead frame portions 109, 104 provide support and rigidity while assembling the package.

The substrate 102 is positioned in the center opening 118 between the first and second lead frame portions 109, 104. The substrate 102 may be composed of organic laminate or other suitable materials. The substrate 102 includes a first substrate sidewall 133 and a second substrate sidewall 135, the second substrate sidewall 135 being opposite to the first substrate sidewall 133. The first and second substrate sidewalls 133, 135 have a second sidewall thickness 134. The second sidewall thickness 134 is less than the first sidewall dimension 132, having a thickness of less than or equal to 0.10 millimeters (mm).

The substrate 102 includes a first contact surface 120 and a second contact surface 122, the second contact surface 122 being opposite to the first contact surface 120. The first and second substrate sidewalls 133, 135 extend from the first contact surface 120 of the substrate 102 to the second contact surface 122 of the substrate 102. The first contact surface 102 of the substrate 102 includes a plurality of contact pads 130, which may be formed on or in the substrate. The plurality of contact pads 130 are positioned along the exposed surface of the semiconductor package 100. The substrate 102 further includes metal traces (not shown) that extend throughout the substrate and are coupled to the first contact surface 120 and the second contact surface 122. This package may be a land grid array (LGA) arrangement.

A first die 110 is attached to the substrate 102 by a die attach film (DAF) or similar adhesive 108. The adhesive may be thinner than the first die. The first die 110 may be an application specific integrated circuit or other micro-electromechanical system (MEMS) sensor die. The first die 110 is positioned on the substrate 102 in the center opening 118 of the semiconductor package 100 between the leads 104, 109. The first die 110 has a first contact surface 126 and a second contact surface 128, the second contact surface 128 opposite to the first contact surface 126. The first die 110 includes a first sidewall 131 and a second sidewall 137, the first sidewall 131 being opposite to the second sidewall 137 and transverse to the first and second contact surfaces 126, 128. The first die 110 further includes a third sidewall dimension or thickness 136, the third sidewall thickness 136 being less than the first sidewall thickness 132.

A first pair of wires 112a, 112b, have first ends coupled to the second contact surface 128 of the first die 110. The first pair of wires 112a, 112b include second ends opposite to the first ends. The second ends are coupled to the second contact surface 122 of the substrate 102, and coupled to the second contact surface 113 of the first lead frame portion 109, respectively.

A second pair of wires 114a, 114b have first ends coupled to the second contact surface 128 of the first die 110. The second pair of wires 114a, 114b include second ends opposite to the first ends. The second ends are coupled to the second contact surface 122 of the substrate 102, and coupled to the second contact surface 106 of the second lead frame portion 104. Electrical signals can be transmitted from the first and second pair of wires 112a, 12b, 114a, and 114b to both the substrate 102 and to the first and second lead frame portions 109, 104. The first and second pair of wires 112a, 112b, 114a, and 114b create a fourth dimension or thickness 138. The fourth dimension 138 is measured from the first contact surface 111, 105 of the first and second lead frame portions 109, 104 to the curvature of the first and second pair of wires (112a, 112b, 114a, 114b), the fourth dimension 138 having a thickness as low as 0.05-millimeters (mm). In some embodiments, the stack of the first die 110, the adhesive 108, and the substrate 102 is less than the fourth dimension 138.

As discussed earlier, the first and second lead frame portions 109, 104, the substrate 102, the first die 110, and the first and second pair of wires 112a, 112b, 114a, and 114b are covered by the molding compound 116. The molding compound 116 may be an epoxy, resin, or some other similar non-conductive material used to protect the semiconductor package. The molding compound 116 extends from the external sidewall 124 of the first lead frame portion 109 to the external sidewall 103 of the second lead frame portion 103. The molding compound further extends from the first contact surfaces 111, 105 of the first lead frame portion and the second lead frame portion, creating a fifth thickness 140. The fifth thickness 140 is greater than the stack of the first die 110, the adhesive 108, and the substrate 102. The fifth thickness is also greater than the first sidewall 132.

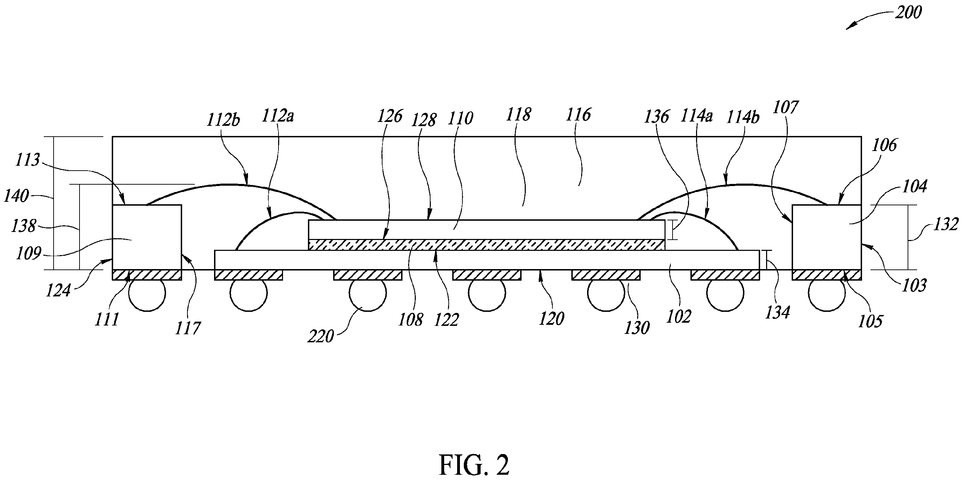

Figure 2 is a cross-sectional view of an alternative embodiment of a semiconductor package 200. Many of the features of the semiconductor package 200 of Figure 2 are similar to those in Figure 1 and have not been described in detail, such as the dimension or thickness of the first, second, third, fourth sidewalls. The semiconductor package 200 includes the first lead frame portion 109, the second lead frame portion 104, and the substrate 102. A plurality of solder balls 220 are coupled to the plurality of contact pads 130. The plurality of solder balls 220 are positioned to enable the package as a ball grid array (BGA).

In Figure 2, the first die 110 is a same width or dimension between the first and second lead frame portions 104, 109 as the adhesive 108. While not illustrated in great detail, contact pads are on the substrate and on the first die. The wires 114a,b and 112a,b are coupled from the contact pads on the first die to either the substrate or the leads. Various arrangements are possible and envisioned. As with Figure 1, the dimension 132 of the lead frame portion 104, between the top and bottom surface of the package is greater than the dimension of the stack of the first die, the adhesive, and the substrate 102.

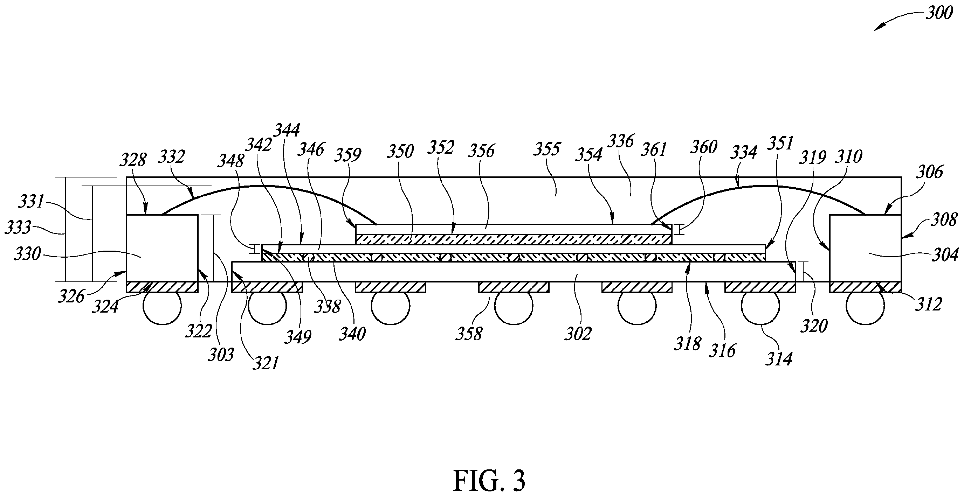

Figure 3 is a cross-sectional view of an alternative embodiment of a semiconductor package 300. The semiconductor package 300 includes a lead frame having a first lead frame portion 330 and a second lead frame portion 304. A substrate 302 is positioned in a center opening 355 between the first lead frame portion and the second lead frame portion. The center opening 355 extends from the first internal sidewall 322 of the first lead frame portion 330 to the second internal sidewall 310 of the second lead frame portion 304. A molding compound 336 covers the first and second lead frame portions 304, 330 and the additional components in the center opening.

A first die 346 is positioned on the substrate 302 in the center opening 355. The first die 346 may be a flip chip die or another application-specific integrated circuit (ASIC) die. The first die 346 has a first contact surface 342 opposite to a second contact surface 344. Coupled to the second contact surface 344 of the first die 346 is a plurality of solder bumps or balls 338. The plurality of solder bumps 338 are substantially surrounded by a flip chip die underfill 340. The flip chip underfill 346 is a non-conductive adhesive that couples the first die 346 to the substrate 302.

The first die 346 includes a first sidewall 349 and a second sidewall 351, the first sidewall 349 opposite to the second sidewall 351 and transverse to the first and second contact surfaces 342, 344. The first sidewall 349 of the first die 346 includes a third sidewall dimension 348. A second die 356 is coupled to the first 346 by an adhesive 350. The second die 356 may be a wire-bonded stacked die, sensing die, or a similar micro-electromechanical systems (MEMS). The second die 356 includes a first contact surface 352 and a second contact surface 354, the second contact surface 354 opposite to the first contact surface 352. The second die 356 further includes a first sidewall 359 and a second sidewall 361, the first and second sidewalls 359, 361 having a sixth dimension or thickness 360.

The first lead frame portion 330 includes a first contact surface 324 and a second contact surface 328, the second contact surface 328 being opposite to the first contact surface 324. The first lead frame portion 330 has a first internal sidewall 322 transverse to the first and second contact surfaces 324, 328. The first internal sidewall 322 having a first sidewall dimension or thickness 303 is adjacent to the substrate 302, opposite a first external sidewall 326. The first sidewall dimension 303 extends from the first contact surface 324 of the first lead frame portion 330 to the second contact surface 328, the first sidewall dimension or thickness 303 having a thickness range less than or equal to 0.20-millimeters (mm). The stack of the first die 346 and the second die 356 is less than the first sidewall dimension 303.

The second lead frame portion 304 includes a first contact surface 312 and a second contact surface 306, the second contact surface 306 being opposite to the first contact surface 312. The second lead frame portion 304 further includes a second internal sidewall 310. The second internal sidewall 310 is transverse to the first and second contact surfaces 312, 306 of the second lead frame portion 304. A second external sidewall 308 is opposite to the second internal sidewall 310 of the second lead frame portion 304 and is transverse to the first and second contact surfaces 312, 306. The second internal sidewall 310 has a thickness or dimension equal to that of the first sidewall thickness 303. The second internal sidewall 310 and second external sidewall 308 extend from the first contact surface 312 of the second lead frame portion 304 to the second contact surface 306 of the second lead frame portion 304.

As previously stated and applicable to this embodiment, the first and second lead frame portions 330, 304 are initially coupled to an adjacent lead frame (not shown) on the next die by a tie bar (not shown) and assembled as part of an array. The tie bar is separated and/or removed during the singulation process, which will be described in further detail below with respect to Figures 4A-4E.

The substrate 302 positioned in the center opening 355 includes a first contact surface 316 and a second contact surface 318, the second contact surface 318 being opposite to the first contact surface 355. The substrate 302 further includes a first sidewall 321 and a second sidewall 319. The first and second substrate sidewalls 321, 319 extend from the first contact surface 316 of the substrate 302 to the second contact surface 318 of the substrate 302. The first and second substrate sidewalls 321, 319 have a second sidewall dimension or thickness 320, the second sidewall dimension or thickness 320 having a thickness of less than or equal to 0.10 millimeters (mm).

The first contact surface 316 of the substrate 302 is coupled to and coplanar to a plurality of contact pads 358. The plurality of contact pads 358 are positioned along the exposed surface of the semiconductor package 300. The substrate 302 further includes metal traces (not shown) on both the first contact surface and the second surface. The plurality of contact pads 358 are coupled to a plurality of solder balls 314.

A pair of wires or connectors 332, 334 have first ends that are coupled to the second contact surface 354 of the second die 356. The pair of wires 332, 334 further include second ends opposite to the first ends. The second ends are coupled to the second contact surfaces 328, 306 of the first and second lead frame portions 330, 304. The curvature height of the pair of wires is a fourth dimension 331. The fourth dimension 331 is measured from the first contact surfaces 324, 312 of the first and second lead frame portions 330, 304 to the curvature of the pair of wires 332, 334, the fourth dimension 331 having a thickness as low was 0.05-millimeters (mm).

The molding compound 336 covers the first and second lead frame portions 330, 304, the substrate 302, the first die 346, the second die 356, and the pair of wires 332, 334. The molding compound 336 may be an epoxy, resin, or other similar non-conductive material used to protect the package. The molding compound 336 extends from external sidewall 326 of the first lead frame portion 330 to the external sidewall 308 of the second lead frame portion 304. The molding compound 336 further extends from the first contact surfaces 324, 312 of the first and second lead frame portions 330, 304 to a distance encompassing the pair of wires 332, 334, creating a fifth dimension or thickness 333. The fifth dimension 333 may be substantially equal to or greater than the summation of the dimensions of the first, second, third, fourth, and sixth sidewall dimensions (303, 320, 348, 331, and 360).

Figures 4A-4E are directed to steps in a method of manufacturing the semiconductor package 100 of Figure 1. Figure 4A is a cross-sectional view of a step of forming a semiconductor package 100 that begins with a lead frame array, each lead frame including a first lead frame portion 104 and a second lead frame portion 109 affixed to a lead frame carrier tape 414. Each of the lead frames 109, 104 have a first contact surface 111, 105 and a second contact surface 113, 106. The first contact surface 111, 105 is positioned on the lead frame carrier tape 414, opposite to the second contact surface 113, 106. Each lead frame 109, 104 has an opening 406 that separates and spaces a lead frame internal sidewall 117, 107 from a lead frame external sidewall 404, the first and second lead frame sidewalls having a first sidewall dimension 132. The center opening 118 is positioned between the first and second lead frames 109, 104. The first and second lead frames 109, 104 are coupled to the adjacent lead frame (not shown) on the next die over by a tie bar (not shown), which is removed later during the process.

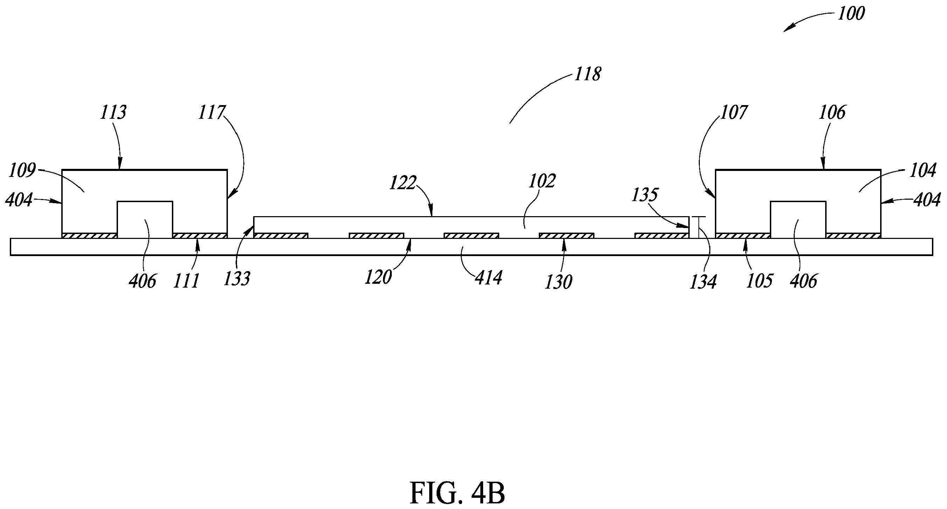

Figure 4B is a cross-sectional view of another step of the process of forming the semiconductor package 100 having a substrate 102 affixed to the lead frame carrier tape 414. The substrate having a plurality of contact pads 130 facing the tape, is placed in the center opening 118 between the first lead frame 109 and the second lead frame 104. A first contact surface 120 of the substrate 102 is in direct contact with the lead frame carrier tape 414, coplanar to the plurality of contact pads 130. The substrate 102 has a first sidewall 133 opposite a second sidewall 135, the first and second sidewall 133, 135 having a second sidewall dimension 134.

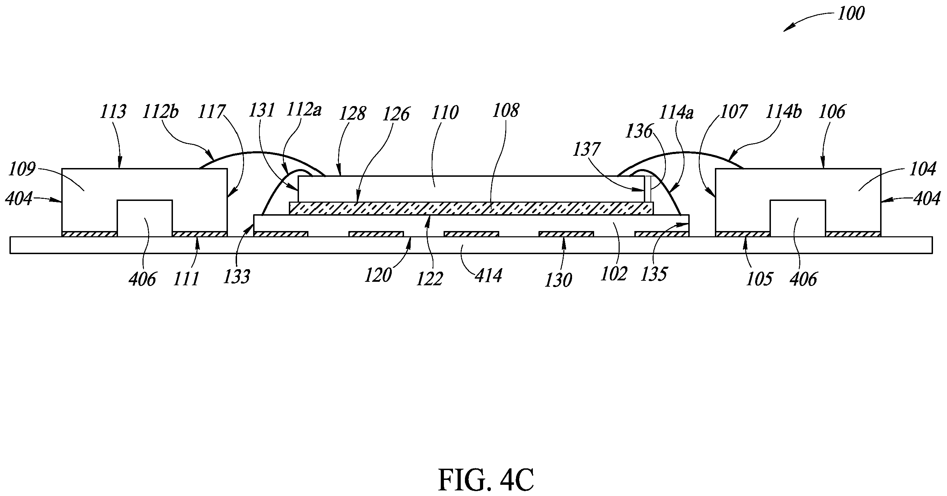

Figure 4C is a cross-sectional view having a first die 110 coupled to the substrate 102 using an adhesive 108. The first die 110 is placed on the substrate 102 in the center opening 118 between the first lead frame 109 and the second lead frame 104. The first die 110 has a first contact surface 126 and a second contact surface 128. The first die 110 further includes a first sidewall 131 that is opposite to a second sidewall 137, each sidewall having a third sidewall dimension 136 being adjacent to the lead frame internal sidewalls 117, 107. A first pair of wires 112a, 112b, are coupled from the second contact surface 128 of the first die 110 to the second contact surface 122 of the substrate 102 and the second contact surface 113 of the first lead frame 109. A second pair of wires 114a 114b are coupled to the second contact surface 122 of the substrate and second contact surface 106 of the second lead frames 104.

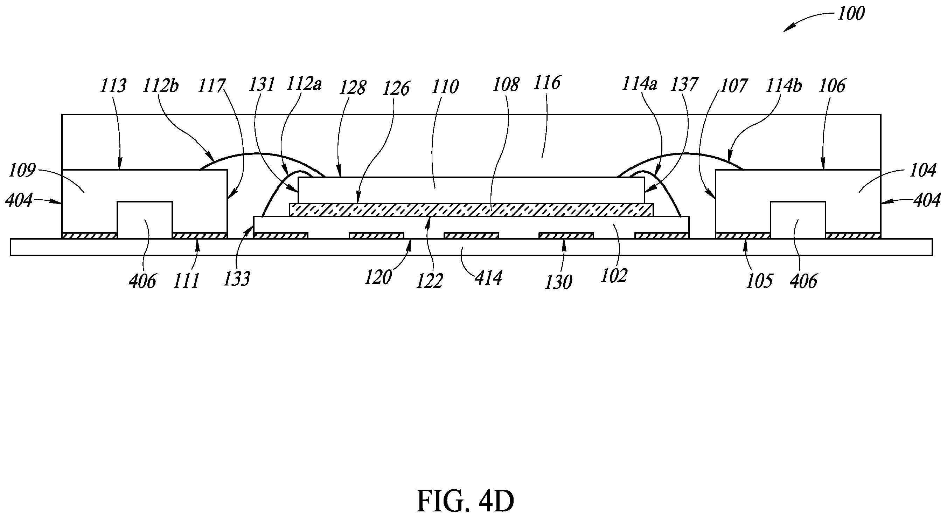

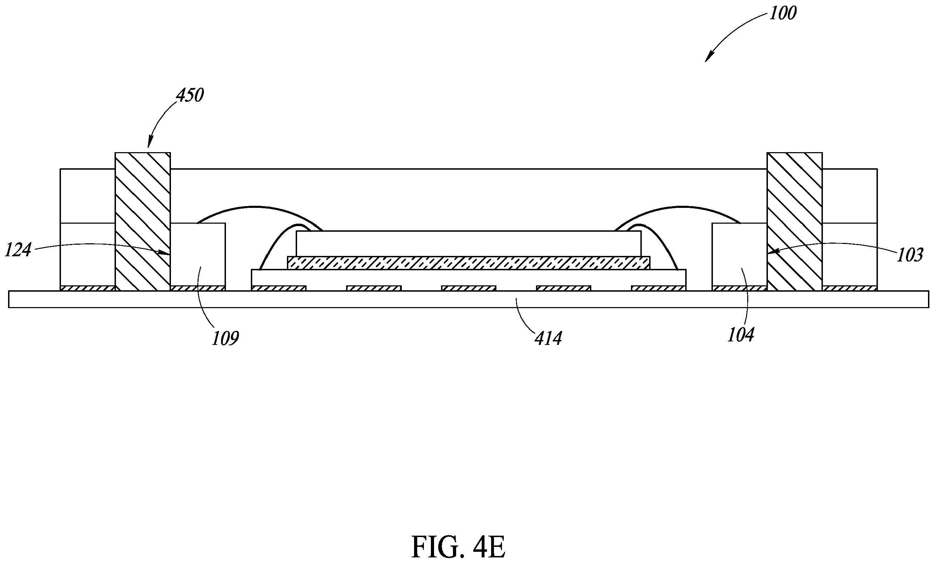

Figure 4D is a cross-sectional view after forming a molding compound 116 that encapsulates the first and second lead frames 109, 104, the substrate 102, the first die 110, and the plurality of wires 112a, 112b, 114a, and 114b. Figure 4E is a cross-sectional view of a technique for separating the adjacent semiconductor packages by cutting or punching through a middle of each of the first and second lead portions. The cutting 450 may occur through the opening 406 in the first and second lead portions. The plurality of packages are singulated 450 while on the lead frame carrier tape 414 to separate the individual units using a mechanical singulation blade or saw. Singulation 450 of each unit occurs at each lead frame forming a first external sidewall 124 of the first lead frame portion 109 and a second external sidewall 103 of the second lead frame portion 104.

The present disclosure is directed to a device that includes a first lead frame portion having a first contact surface opposite to a second contact surface, and a first sidewall transverse to the first and second contact surface, a second lead frame portion having a first contact surface opposite to a second contact surface, a center opening between the first lead frame portion and the second lead frame portion, a substrate in the center opening between the first lead frame portion and the second lead frame portion, the substrate having a first surface and a second surface opposite the first surface, a second sidewall, the second sidewall being smaller than the first sidewall, a first die on the substrate, the first die having a third sidewall, the first sidewall being larger than the second sidewall and the third sidewall, and a molding compound covering the first and second lead frame portions, the first die, and the substrate.

The device includes the first lead frame portion and the second lead frame portion have a first sidewall dimension of less than or equal to 0.20 millimeters (mm). The substrate has a second sidewall dimension of less than or equal to 0.10 millimeters (mm). The molding compound has a dimension of the combination of the first sidewall, the second sidewall, and the third sidewall. The first die is a micro-electromechanical system.

The first lead frame portion includes a fourth external sidewall transverse to the first and second contact surface, the fourth external sidewall substantially the same as the first sidewall; and the fourth external sidewall being greater than the second sidewall of the substrate. A fourth dimension of the peak curvature of a plurality of connectors on the second surface of the first die is equal to or less than 0.05 millimeters (mm). The substrate is composed of an organic laminate material. The first surface of the substrate has a plurality of contacts coplanar with the first contact surface of the first and second lead frame portions. A plurality of solder balls coupled to the plurality of contact pads on the first contact surface of the substrate and the first contact surface of the first and second lead frame portions.

The present disclosure is directed to a device having a lead frame having a first dimension in a first direction; an opening in the lead frame; a substrate in the opening in the lead frame, the substrate having a second dimension in the first direction, the first dimension being greater than the second dimension; and a first die on the substrate, the first die and the substrate having a third dimension in the first direction, the first dimension being greater than the third dimension.

A plurality of wires, a first set of the plurality of wires coupled between the first die and the substrate, a second set of the plurality of wires coupled between the first die and the lead frame. The substrate has a first surface opposite a second surface, the first die being on the first surface, at least one of the plurality of wires has a curvature where a fourth dimension from a peak of the curvature to the second surface of the substrate is less than or equal to 0.20 millimeters (mm). A molding compound covering the lead frame, the opening, the substrate, and the first die. A fifth dimension including the molding compound is equal to or greater than the summation of the first, second, third, and fourth dimensions.

The present disclosure is directed to a method of forming a plurality of layers on a carrier tape using a lead frame, forming a plurality of layers including: forming a plurality of lead frame portions, the lead frame portions having a first side opposite a second side, a first surface coupled to the carrier tape, opposite a second surface transverse to the first side and second side; the first side facing a center opening between the lead frame portions and the second side facing externally; placing a substrate in the center opening between the lead frame portions, the substrate having a first surface opposite a second surface; coupling a first die to the substrate by an adhesive, the first die having a first surface opposite a second surface; forming a molding compound encapsulating the lead frame portions, the substrate, the first die, and the plurality of wires; and singulating a portion of the lead frame portions, the substrate, the first die, the plurality of wires, and the molding compound forming a semiconductor package.

The plurality of wires are placed on the first die having a curvature height equal to or less than 0.05 millimeters (mm). Singulating the portion of the lead frame portions creates a new external sidewall of the first and second lead frame portions. The lead frame portions, the substrate, the first die, and the molding compound have a total combination thickness of less than or equal to 1.0 millimeter (mm). The various embodiments described above can be combined to provide further embodiments. All of the U.S. patents, U.S. patent application publications, U.S. patent applications, foreign patents, foreign patent applications and non-patent publications referred to in this specification and/or listed in the Application Data Sheet are incorporated herein by reference, in their entirety. Aspects of the embodiments can be modified, if necessary to employ concepts of the various patents, applications and publications to provide yet further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A device, comprising:
a first lead frame portion having a first contact surface opposite to a second contact surface, and a first sidewall transverse to the first and second contact surface;
a second lead frame portion having a first contact surface opposite to a second contact surface;
a center opening between the first lead frame portion and the second lead frame portion;
a substrate in the center opening between the first lead frame portion and the second lead frame portion, the substrate having a first surface and a second surface opposite the first surface, a second sidewall, the second sidewall being smaller than the first sidewall;
a first die on the substrate, the first die having a third sidewall, the first sidewall being larger than the second sidewall and the third sidewall; and
a molding compound covering the first and second lead frame portions, the first die, and the substrate.

2. The device of claim 1, wherein the first lead frame portion and the second lead frame portion have a first sidewall dimension of less than or equal to 0.20 millimeters (mm).

3. The device of claim 1 or 2, wherein the substrate has a second sidewall dimension of less than or equal to 0.10 millimeters (mm).

4. The device of any of claims 1 to 3, wherein the molding compound has a dimension of the combination of the first sidewall, the second sidewall, and the third sidewall.

5. The device of any of claims 1 to 4, wherein the first die is a micro-electromechanical system.

6. The device of any of claims 1 to 5, wherein the first lead frame portion includes a fourth external sidewall transverse to the first and second contact surface, the fourth external sidewall substantially the same as the first sidewall; and the fourth external sidewall being greater than the second sidewall of the substrate.

7. The device of any of claims 1 to 6, wherein a fourth dimension of the peak curvature of a plurality of connectors on the second surface of the first die is equal to or less than 0.05 millimeters (mm).

8. The device of any of claims 1 to 7, wherein the substrate is composed of an organic laminate material.

9. The device of any of claims 1 to 8, wherein the first surface of the substrate has a plurality of contacts coplanar with the first contact surface of the first and second lead frame portions.

10. The device of any of claims 1 to 9, further comprising a plurality of solder balls coupled to the plurality of contact pads on the first contact surface of the substrate and the first contact surface of the first and second lead frame portions.

11. The device of any of claims 1 to 10, wherein the molding compound is composed of resin.

12. A device, comprising:
a lead frame having a first dimension in a first direction;
an opening in the lead frame;
a substrate in the opening in the lead frame, the substrate having a second dimension in the first direction, the first dimension being greater than the second dimension; and
a first die on the substrate, the first die and the substrate having a third dimension in the first direction, the first dimension being greater than the third dimension.

13. The device of claim 12, further comprising a plurality of wires, a first set of the plurality of wires coupled between the first die and the substrate, a second set of the plurality of wires coupled between the first die and the lead frame.

14. The device of claim 12 or 13, wherein the substrate has a first surface opposite a second surface, the first die being on the first surface, at least one of the plurality of wires has a curvature where a fourth dimension from a peak of the curvature to the second surface of the substrate is less than or equal to 0.20 millimeters (mm).

15. The device of any of claims 12 to 14, further comprising a molding compound covering the lead frame, the opening, the substrate, and the first die.

16. The device of claim 15 wherein a fifth dimension including the molding compound is equal to or greater than the summation of the first, second, third, and fourth dimensions.

17. A method, comprising:
forming a plurality of layers on a carrier tape using a lead frame, forming a plurality of layers including:
forming a plurality of lead frame portions, the lead frame portions having a first side opposite a second side, a first surface coupled to the carrier tape, opposite a second surface transverse to the first side and second side; the first side facing a center opening between the lead frame portions and the second side facing externally;
placing a substrate in the center opening between the lead frame portions, the substrate having a first surface opposite a second surface;
coupling a first die to the substrate by an adhesive, the first die having a first surface opposite a second surface;
forming a molding compound encapsulating the lead frame portions, the substrate, the first die, and the plurality of wires; and
singulating a portion of the lead frame portions, the substrate, the first die, the plurality of wires, and the molding compound forming a semiconductor package.

18. The method of claim 17, wherein the plurality of wires are placed on the first die having a curvature height equal to or less than 0.05 millimeters (mm).

19. The method of claim 17 or 18, wherein singulating the portion of the lead frame portions creates a new external sidewall of the first and second lead frame portions.

20. The method of any of claims 17 to 19, wherein the lead frame portions, the substrate, the first die, and the molding compound have a total combination thickness of less than or equal to 1.0 millimeter (mm).
